# FASCICULE DE BREVET EUROPEEN

(11) **EP 2 756 278 B1**
(45) Date de publication et mention de la délivrance du brevet: **24.06.2015**
(21) Numéro de dépôt: 12750474.4
(22) Date de dépôt: 03.08.2012
(51) Int. Cl.: H01L 41/193, G01L 9/08, G01L 9/06, G01L 9/00, G01L 1/16, H01L 41/113

(54) **CAPTEUR DE PRESSION PIEZOELECTRIQUE**
PIEZOELEKTRISCHER DRUCKSENSOR
PIEZOELECTRIC PRESSURE SENSOR

(30) Priorité: 14.09.2011 FR 1158179
(43) Date de publication de la demande: 23.07.2014
(73) Titulaire: Commissariat à l'Énergie Atomique et aux Énergies Alternatives, 75015 Paris (FR)
(72) Inventeur: BENWADIH, Mohammed, F-94500 Champagny Sur Marne (FR); ALIANE, Abdelkader, F-38000 Grenoble (FR)
(74) Mandataire: Cabinet Laurent & Charras
(86) Numéro de dépôt international: PCT/FR2012/051843
(87) Numéro de publication internationale: WO 2013/038083

(56) Documents cités:
- WO-A2-2010/022038

## Description

### DOMAINE TECHNIQUE

La présente invention concerne un capteur de pression et plus particulièrement un capteur de pression comprenant un matériau piézoélectrique.

### ART ANTERIEUR

Afin de mesurer une pression, c'est-à-dire une force appliquée sur une surface, il est bien connu d'utiliser différents types de capteur de pression.

Les capteurs de pression les plus courants sont les capteurs à jauge de contrainte. Ces capteurs fonctionnent en mettant en oeuvre l'effet piézo-résistif, c'est à dire l'effet d'une pression sur les caractéristiques d'une résistance appelée jauge de contrainte. La variation géométrique d'une jauge de contrainte se traduit par une variation de sa résistance. Ces capteurs comportent quatre jauges de contraintes, telles qu'une jauge à fil, une jauge à trame pelliculaire ou une jauge à semi-conducteur par exemple, montées en pont de Wheatstone sur un corps d'épreuve déformable. Les variations des résistances des jauges permettent alors de déterminer la pression exercée sur le corps d'épreuve.

Toutefois, bien que ces capteurs de pression soient robustes et fiables, ils présentent une faible sensibilité.

On connaît également des capteurs de pression à capacité variable constitués d'un diaphragme, d'une plaque métallique statique, d'un matériau isolant et d'un diélectrique. La capacité entre deux plaques de métal, à savoir le diaphragme et la plaque statique, se modifie quand la distance qui les sépare varie, c'est-à-dire quand une pression est exercée sur le diaphragme.

Ce type de capteur de pression à capacité variable permet de mesurer la variation de capacité entre un diaphragme métallique et une plaque de métal fixe, et sont généralement très stables et linéaires ; toutefois, ces capacités sont sensibles aux températures élevées et sont plus complexes à mettre en place que la plupart des capteurs de pression.

Enfin, on connaît également les capteurs de pression piézoélectriques qui fonctionnent selon le principe piézoélectrique. Ainsi, un matériau piézoélectrique, tel que le quartz par exemple, se charge électriquement lorsque ledit matériau est soumis à une sollicitation mécanique telle qu'une pression. La charge électrique est proportionnelle à la force qui s'exerce sur le matériau piézoélectrique et se mesure en picocoulombs.

Ainsi, pour mesurer une pression au moyen d'un capteur de pression piézoélectrique, il convient de mesurer la tension apparaissant aux bornes du matériau piézoélectrique.

Néanmoins, il est particulièrement difficile de mesurer de faibles variations de tension de sorte que ces capteurs de pression piézoélectriques sont considérés comme peu sensibles, c'est-à-dire ne permettant pas de mesurer de faibles pressions ou de faibles variations de pression.

### EXPOSE DE L'INVENTION

L'un des buts de l'invention est de remédier aux inconvénients de ces capteurs de pression piézoélectriques en proposant un capteur de pression comportant un matériau piézoélectrique de conception simple et peu onéreuse et procurant une grande sensibilité des mesures.

A cet effet, et conformément à l'invention, il est proposé un capteur de pression comprenant un matériau piézoélectrique. Ce capteur comprend un substrat inférieur sur lequel sont déposées deux électrodes partiellement recouvertes par une couche semi-conductrice, une couche piézoélectrique étant positionnée en contact avec la couche semi-conductrice de telle manière que le matériau semi-conducteur soit en contact avec le matériau piézoélectrique et avec les deux électrodes. La couche piézoélectrique est systématiquement en contact avec les électrodes Lesdites électrodes sont destinées à être connectées à une source de tension ou à un dispositif de mesure de l'intensité d'un courant généré par le déplacement des charges électriques dans la couche semi-conductrice entre les électrodes, lesdites charges électriques étant créées lorsqu'une pression est exercée sur la couche piézoélectrique.

On comprend bien que le capteur de pression selon l'invention permet de transférer les charges, créées lorsqu'une pression est exercée sur la couche piézoélectrique, dans un semi-conducteur qui est en contact électrique avec cette dernière.

L'application d'une tension entre les deux électrodes précitées permet de transférer les charges dans le semi-conducteur et de récupérer un courant électrique proportionnel à la pression appliquée, la mesure du courant étant beaucoup plus fiable que la mesure de tension utilisée dans les capteurs piézoélectriques de l'art antérieur.

Selon un mode de réalisation de l'invention, le capteur comprend en outre une couche diélectrique réalisée en un matériau diélectrique, insérée localement entre la couche piézoélectrique et la couche semi-conductrice.

Selon une caractéristique avantageuse du capteur de pression selon l'invention, la couche piézoélectrique comporte des dipôles alignés selon la direction de pression exercée, ce qui permet d'augmenter le nombre de charges collectées, et donc d'augmenter la sensibilité du capteur. Cet alignement peut se faire une seule fois avant l'utilisation du capteur. Les dipôles de la couche piézoélectrique sont avantageusement alignés en appliquant un champ électrique entre des électrodes choisies judicieusement.

De préférence, le champ électrique appliqué entre les électrodes est compris entre 0,3 et 0,7 volt par micromètre à une température comprise entre 40 et 60 °C pendant une durée comprise entre 20 minutes et 8 heures. En effet, la température améliore la mobilité des charges, de sorte que l'alignement est obtenu plus rapidement et/ou de manière plus complète.

Par ailleurs, le substrat inférieur est avantageusement réalisé en un matériau choisi dans le groupe comprenant le verre, le silicium dopé ou non, les polymères tels que polyéthylène téréphtalate (PET), polyéthylène naphtalate (PEN), polyimides (PI), polycarbonate, acrylates, etc.

De préférence, la couche semi-conductrice est réalisée en un matériau choisi dans le groupe comprenant :
- les molécules organiques semi-conductrices telles que tetracene, pentancene, phtalocyanine,
- les polymères semi-conducteurs tels que polytiophène, polyfluorène, polyphenylene vinylene ou leurs dérivés tels que poly (3-octyl), thiophene, poly [2-methoxy-5-(2'-ethyl-hexyloxy)-1,4-], phenylene, vinylene ou oligomère tel que α-sexithiophènes.

De plus, la couche piézoélectrique est avantageusement réalisée en un matériau choisi dans le groupe comprenant le polyfluoridevinylidène (plyvinylidène fluoré), les copolymères de polyvinylidènefluoride, et le PZT (Plomb - Zinc - Oxyde de titane).

De manière particulièrement avantageuse, le capteur de pression selon l'invention comporte en outre :
- une couche diélectrique déposée sur la couche semi-conductrice,
- une électrode de grille déposée sur la face supérieure de la couche diélectrique,
- une couche isolante déposée sur la couche supérieure de la couche diélectrique et l'électrode de grille,
la couche piézoélectrique étant déposée sur l'ensemble couche semi-conductrice / couche diélectrique / électrode de grille / couche isolante de telle manière que le matériau piézoélectrique soit en contact avec le matériau semi-conducteur et les deux électrodes.

Un tel capteur de pression présente alors une structure de transistor à effet de champ de type à « grille haute », de sorte qu'un même composant peut servir de transistor quand aucune pression n'est appliquée sur la couche piézoélectrique et se transforme en capteur de pression sensible lorsqu'une pression est appliquée sur ladite couche piézoélectrique.

De préférence, le matériau diélectrique est réalisé en un matériau choisi dans le groupe comprenant le dioxyde de silicium, le nitrate de silicium, le dioxyde de titane, l'oxyde d'aluminium, le dioxyde d'hafnium, les polyimides, les polyvinyles, le pyrrolidone, le polyméthylméthacrylate, le polyamide, le parylène, le polystyrène, les fluoropolymères.

De plus, les électrodes sont réalisées en un matériau choisi dans le groupe comprenant les métaux, tels que l'aluminium, le titane, le nickel, l'or, le chrome, etc..., les particules métalliques, les oxydes métalliques tels que l'oxyde d'indium-étain, l'oxyde d'indium-zinc, etc..., les polymères conducteurs tels que 3, 4 - polyéthylène dioxythiophène-polystyrène, sulfonate (PEDOT : PSS) ou polyaniline, etc..., ou les matériaux en silicium dopé.

### DESCRIPTION SOMMAIRE DES FIGURES

D'autres avantages et caractéristiques ressortiront mieux de la description qui va suivre, de plusieurs variantes d'exécution du capteur de pression comprenant un matériau piézoélectrique conforme à l'invention, données à titre d'exemple non limitatifs et en référence aux dessins annexés sur lesquels :
- la figure 1 est une représentation schématique en coupe d'un capteur de pression comprenant un matériau piézoélectrique conforme à l'invention,
- la figure 2 est une vue schématique de dessus du capteur de pression de la figure 1,
- les figures 3A à 3C sont des représentations schématiques des différentes étapes de mesure de la pression exercée sur la couche piézoélectrique du capteur de pression selon l'invention,
- la figure 4 est une représentation graphique de l'intensité du courant en fonction de la tension mesurée aux bornes des électrodes du capteur de pression selon l'invention,
- la figure 5 est une représentation schématique d'une variante d'exécution de la polarisation de la couche piézoélectrique du capteur de pression selon l'invention,
- la figure 6 est une représentation schématique en coupe d'une variante d'exécution du capteur de pression selon l'invention,
- la figure 7 est une vue schématique de dessus de la figure 6.
- la figure 8 est une vue analogue à la figure 6, d'une variante d'exécution de l'invention.
- la figure 9 est une vue analogue à la figure 1, illustrant un capteur de pression en mode transistor « grille basse ».

### DESCRIPTION DETAILLEE DE L'INVENTION

Par souci de clarté, dans la suite de la description, les mêmes éléments ont été désignés par les mêmes références au sein des différentes figures. De plus, les diverses vues en coupe ne sont pas nécessairement tracées à l'échelle.

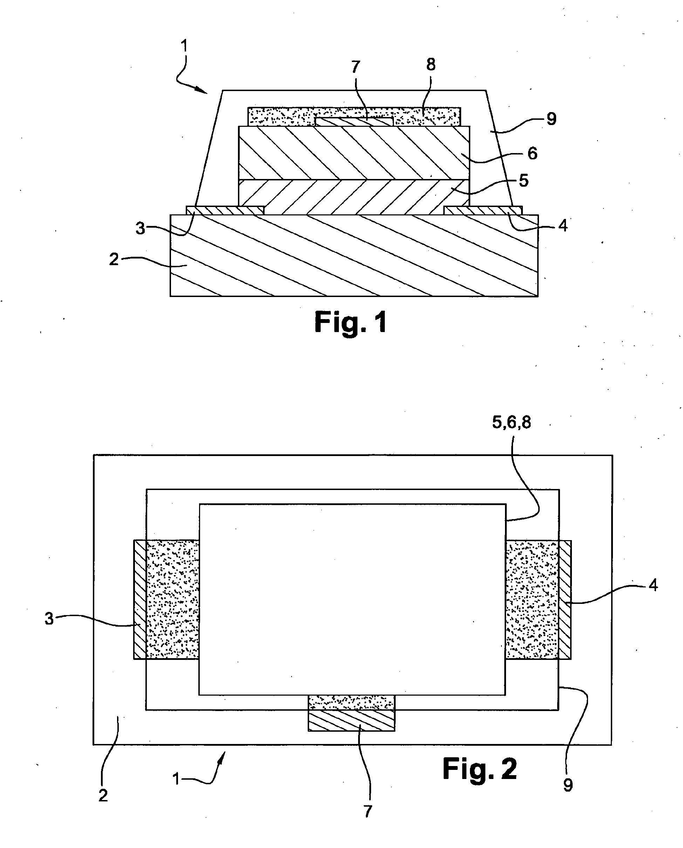

En référence aux figures 1 et 2, le capteur de pression 1 selon l'invention comprend un substrat inférieur 2, sur lequel sont déposées deux électrodes 3, 4, respectivement une électrode de source 3 et une électrode de drain 4.

Le substrat inférieur 2 est réalisé en un matériau choisi dans la liste suivante : verre, substrat de silicium dopé ou non, polymères tels que polyéthylène téréphtalate (PET), polyéthylène naphtalate (PEN), polyimide (PI), polycarbonate, acrylates, etc.

Il est cependant bien évident que le substrat inférieur 2 peut être obtenu dans tout autre matériau bien connu de l'homme du métier.

Par ailleurs, les électrodes de source 3 et de drain 4 sont réalisées en métal, tel que l'aluminium, le titane, le nickel, l'or, le chrome, etc..., ou en particules métalliques, en oxydes métalliques, tels que l'oxyde d'indium-étain, l'oxyde d'indium-zinc, etc..., voire en polymères conducteurs, tels que le 3, 4 - polyéthylène dioxythiophène-polystyrène, sulfonate (PEDOT : PSS), la polyaniline, etc..., en silicium dopé ou dans tout autre matériau conducteur approprié bien connu de l'homme du métier.

Lesdites électrodes de source **3** et de drain **4** sont partiellement recouvertes par une couche semi-conductrice **5** réalisée en matériau semi-conducteur. En outre, une couche diélectrique **6** réalisée en matériau diélectrique est déposée sur la couche semi-conductrice **5**.

Ladite couche semi-conductrice **5** est avantageusement réalisée en un matériau organique semi-conducteur du type tetracene, pentancene, phtalocyanine, polymères semi-conducteurs tels que polythiophène, polyfluorène, polyphenylene vinylene ou leurs dérivés tels que poly (3-octyl), thiophene, poly [2-methoxy-5-(2'-ethyl-hexyloxy)-1,4-], phenylene, vinylene ou oligomère tel que α-sexithiophènes.

Toutefois, la couche semi-conductrice **5** peut également être réalisée en un matériau inorganique semi-conducteur bien connu de l'homme du métier tel que le silicium ou l'arséniure de gallium (GaAs) par exemple, sans pour autant sortir du cadre de l'invention.

Ladite couche diélectrique **6** est réalisée en dioxyde de silicium, nitrate de silicium, dioxyde de titane, oxyde d'aluminium, dioxyde d'hafnium, ou encore en polyimide, polyvinyle, pyrolidone, polyméthylméthacrylate, polyamide, parylène, polystyrène, fluoropolymères, ou dans tout autre matériau diélectrique bien connu de l'homme du métier.

Le capteur comporte par ailleurs une électrode de grille **7,** déposée sur la face supérieure de la couche diélectrique **6.** L'électrode de grille 7 et la couche diélectrique **6** sont recouvertes par une couche isolante **8** procurant une isolation électrique.

Une couche piézoélectrique **9** réalisée en un matériau piézoélectrique, est déposée sur l'ensemble constitué par la couche isolante **8,** la couche diélectrique **6** et la couche semi-conductrice **5,** de telle manière que le matériau semi-conducteur de la couche semi-conductrice **5** soit en contact d'une part avec le matériau piézoélectrique de la couche piézo-électrique **9,** et d'autre part avec les électrodes de source **3,** de drain **4** et de grille **7.**

La couche piézo-électrique **9** est isolée électriquement par rapport à l'électrode de grille **7.**

L'électrode de grille **7** est réalisée en un matériau de même nature que celui constitutif des électrodes de source **3** et de drain **4.**

La couche isolante **8** est obtenue par dépôt d'un matériau diélectrique choisi parmi les matériaux constitutifs de la couche **6** (cf. supra), et la couche piézoélectrique **9** est réalisée en un matériau choisi dans la liste suivante : polyvinylidène fluoride (PVDF), les copolymères de polyvinylidène fluoride tels que PVDF-TrFE ou PVDF-TFE ou dans tout autre matériau présentant des propriétés piézo-électriques bien connu de l'homme du métier.

Ladite couche piézoélectrique **9** présente de préférence une épaisseur comprise entre 1 et 40 micromètres, ladite épaisseur dépendant notamment de la valeur de la pression à mesurer, c'est-à-dire son ordre de grandeur, et de la nature du matériau piézoélectrique constitutif de la couche piézoélectrique **9.** L'homme du métier n'aura pas de difficultés pour adapter l'épaisseur de la couche piézoélectrique en fonction de ces deux facteurs.

Par ailleurs, la couche piézoélectrique **9** comporte des dipôles alignés, lesdits dipôles étant alignés dans le sens de la pression à mesurer. Après le dépôt de la couche piézoélectrique **9,** les dipôles sont désordonnés. Afin d'aligner les dipôles de la couche piézoélectrique **9,** on applique un champ électrique E entre deux électrodes, l'électrode de source 3 et l'électrode de drain **4** par exemple, à une valeur comprise entre 0,3 V.m⁻¹ et 0,7 V.m⁻¹ par micromètre d'épaisseur de la couche piézoélectrique **9,** à une température comprise entre 40 et 60 °C et pendant une durée comprise entre 20 minutes et 8 heures.

On peut observer que le capteur de pression **1** ainsi défini présente une structure de transistor organique à effet de champ du type à « grille haute » et « contacts bas ». Ainsi, lorsqu'aucune pression n'est exercée sur ledit capteur, ce dernier peut avantageusement fonctionner normalement comme un transistor organique à effet de champ.

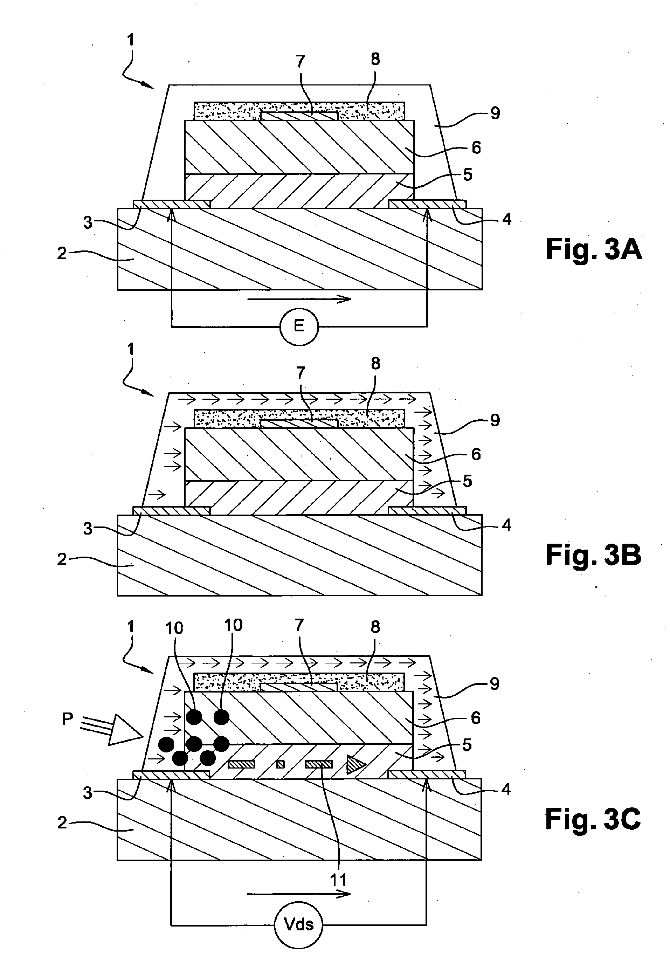

Il va être expliqué ci-après le fonctionnement du capteur de pression 1 selon l'invention à partir d'un exemple de réalisation et en référence aux figures 3A à 3C, 4 et 5.

En référence à la figure 3A, le capteur de pression **1** est obtenu par dépôt de 3 nanomètres d'or sur un substrat de polyéthylène naphthalate (PEN) d'une épaisseur d'environ 125 micromètres. La couche d'or est alors gravée pour définir une électrode de source **3** et une électrode de drain **4.**

On dépose alors par héliogravure une couche semi-conductrice **5** en triisopropylsilyl (TIPS) pentacène d'environ 90 nanomètres d'épaisseur, recouvrant partiellement les électrodes de source **3** et de drain **4.** Cette couche est ensuite recouverte d'une couche diélectrique **6** réalisée en fluoropolymère commercialisé sous la marque CYTOP^{®} par exemple sur une épaisseur d'environ 800 nanomètres.

Ensuite, on dépose 50 nanomètres d'or sur ladite couche diélectrique **6** pour former l'électrode de grille **7,** puis une couche isolante réalisée en CYTOP^{®} sur une épaisseur d'environ 1 micromètre, et finalement on dépose une couche piézoélectrique **9** de polyvinylidène fluoride (PVDF) ou d'un copolymère de polyvinylidène fluoride tels que PVDF-TrFE ou P(VDF-TFE) sur une épaisseur d'environ 1 micromètre.

Afin d'aligner les dipôles de la couche piézoélectrique **9** pour permettre la réalisation d'une mesure de pression latérale, c'est à-dire pour la mesure d'une pression exercée sur un bord latéral de la couche piézoélectrique **9,** un champ électrique E est appliqué entre les électrodes de source **3** et de drain **4.** Ce champ électrique E présente une intensité de 0,5 V/µm et il est appliqué à une température de 50°C pendant 30 minutes.

En référence à la figure 3B, les dipôles de la couche piézoélectrique **9** sont alors alignés parallèlement au substrat inférieur **2.**

Lorsqu'une pression est exercée sur l'un des bords latéraux de la couche piézoélectrique **9,** en référence à la figure 3C, des charges **10** se créent dans ladite couche piézoélectrique au niveau du point de pression. En appliquant une tension dite V_{DS} entre l'électrode de drain **4** et l'électrode de source **3,** les charges **10** sont transférées dans la couche semi-conductrice **5** et passent dans le canal de conduction **11** située entre l'électrode de source **3** et l'électrode de drain **4.**

Le déplacement des charges **10** dans le canal de conduction **11** de la couche semi-conductrice **5** induit une augmentation du courant I_{DS} mesuré aux bornes des électrodes de source **3** et de drain **4.**

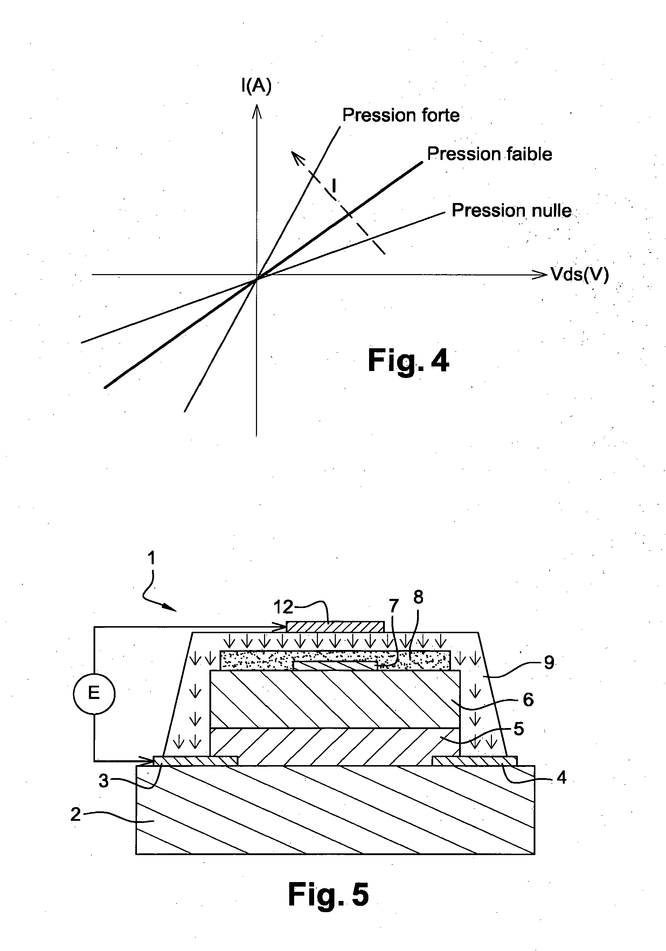

Comme on peut le voir sur la figure 4, le courant I_{DS} mesuré aux bornes des électrodes de source **3** et de drain **4** est proportionnel à la pression exercée sur le bord latéral de la couche piézoélectrique **9.** Ainsi, une augmentation de la pression latérale exercée sur la couche piézoélectrique **9** engendre une augmentation proportionnelle du courant I_{DS} par accumulation et transport des charges dans le canal de conduction **11** de la couche semi-conductrice **5.**

Afin de permettre la mesure d'une pression verticale, en référence à la figure 5, il est nécessaire préalablement d'aligner verticalement les dipôles de la couche piézoélectrique **9.** A cet effet, une électrode **12** est positionnée sur la surface supérieure de la couche piézoélectrique **9,** puis un champ électrique E est appliqué entre ladite électrode **12** et l'électrode **3,** ou entre l'électrode **12** et l'électrode **4,** voire entre l'électrode **12** et les électrodes **3** et **4.** Ce champ électrique E présente une intensité de 0,5 V/µm et il est appliqué à une température de 50°C pendant 30 minutes à plusieurs heures.

Les dipôles de la couche piézoélectrique **9** sont alors alignés verticalement. Lorsqu'une pression est exercée sur la surface supérieure de la couche piézoélectrique **9,** des charges **10** se créent dans la couche piézoélectrique **9** au niveau du point de pression.

En appliquant une tension dite V_{DS} entre l'électrode de drain **4** et l'électrode de source **3,** de la même manière que précédemment, les charges **10** sont transférées dans la couche semi-conductrice **5** et passent dans le canal de conduction **11** située entre l'électrode de source **3** et l'électrode de drain **4.** Le déplacement des charges **10** dans le canal de conduction **11** de la couche semi-conductrice engendre une augmentation du courant I_{DS} mesuré aux bornes des électrodes de source **3** et de drain **4,** ladite augmentation du courant I_{DS} étant proportionnelle à la pression exercée sur la face supérieure de la couche piézoélectrique **9**.

On notera que pour procéder à l'alignement vertical des dipôles de la couche piézoélectrique **9**, l'électrode de grille 7 peut être utilisée afin d'appliquer le champ électrique E en substitution de l'électrode **12**. Toutefois, l'alignement des dipôles ne sera alors pas parfaitement vertical et les dipôles de la couche piézo-électrique **9** sont susceptibles de créer des capacités parasites qui altèrent les performances du capteur, lorsque ce dernier fonctionne en tant que transistor, c'est-à-dire lorsqu'aucune pression n'est exercée sur la face supérieure de la couche piézoélectrique.

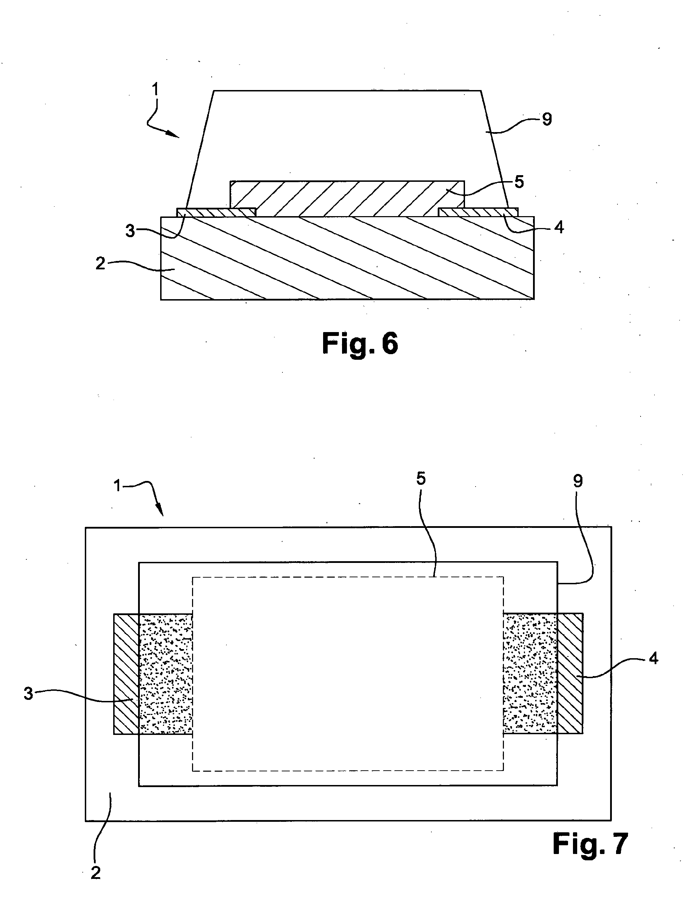

Selon une variante d'exécution du capteur de pression selon l'invention et en référence aux figures 6 et 7, la couche piézoélectrique **9** est déposée sur la couche semi-conductrice **5**, de telle manière que le matériau piézoélectrique de ladite couche **9** soit en contact d'une part avec le matériau semi-conducteur de la couche semi-conductrice **5,** et d'autre part avec les électrodes de source **3** et de drain **4.**

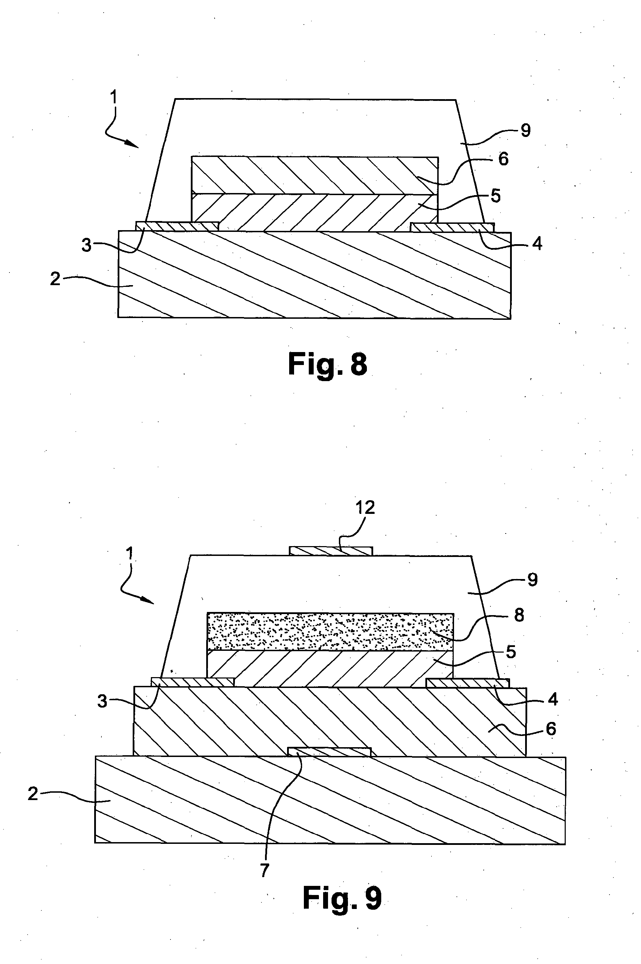

Selon une variante d'exécution représentée à la figure 8, on introduit une couche diélectrique **6** entre la couche piézoélectrique **9** et la couche semi-conductrice **5.** Ce faisant, on dispose :
- d'un fonctionnement en mode « capteur », comme pour le mode de réalisation représenté en relation avec la figure 6 ;
- d'un fonctionnement en mode « transistor », où le rôle de la grille est joué par la couche piézoélectrique **9.** La modulation habituelle de la tension de grille est ici constituée d'une modulation de pression sur la couche piézoélectrique, qui par effet capacitif, ouvre plus ou moins le canal de transport des charges entre les électrodes **3** et **4.**

De la même manière que précédemment, la couche piézoélectrique **9** comporte des dipôles alignés, lesdits dipôles étant alignés dans le sens de la pression à mesurer. Afin d'aligner les dipôles de la couche piézo-électrique **9,** on applique un champ électrique E entre l'électrode de source **3** et l'électrode de drain **4** par exemple, à une intensité comprise entre 0,3 et 0,7 V.m⁻¹ par micromètre d'épaisseur de la couche piézoélectrique **9,** à une température comprise entre 40 et 60 °C et pendant une durée comprise entre 20 minutes et 8 heures.

Le fonctionnement du capteur est strictement identique au fonctionnement du capteur précédemment décrit à l'exception près que cette variante d'exécution du capteur de pression n'est pas susceptible de fonctionner comme un transistor organique à effet de champ.

Enfin, il est bien évident que les exemples que l'on vient de donner ne sont que des illustrations particulières en aucun cas limitatives quant aux domaines d'application de l'invention. Il est ainsi possible de réaliser un capteur de pression conforme à l'invention avec une structure transistor « grille basse », tel que représenté sur la figure 9.

## Revendications

1. Capteur de pression (1) comprenant un matériau piézoélectrique, ***caractérisé* en ce qu'**il comprend au moins un substrat inférieur (2) sur lequel sont déposés deux électrodes (3, 4) partiellement recouvertes par une couche semi-conductrice (5) réalisée en un matériau semi-conducteur, et une couche piézoélectrique (9) réalisée en un matériau piézoélectrique, et en contact avec la couche semi-conductrice (5) de telle manière que le matériau semi-conducteur soit en contact avec le matériau piézoélectrique et avec les deux électrodes (3, 4), la couche piézoélectrique étant systématiquement en contact avec les électrodes, lesdites électrodes (3, 4) étant aptes à être connectées à une source de tension ou à un dispositif de mesure de l'intensité d'un courant généré par le déplacement de charges électriques (10) dans la couche semi-conductrice (5) entre les électrodes (3, 4), lesdites charges électriques (10) étant créées lorsqu'une pression est exercée sur la couche piézoélectrique (9).

2. Capteur de pression (1) selon la revendication 1, ***caractérisé* en ce qu'**il comprend en outre une couche diélectrique (6) réalisée en un matériau diélectrique, insérée localement entre la couche piézoélectrique (9) et la couche semi-conductrice (5).

3. Capteur de pression (1) selon la revendication 1, ***caractérisé* en ce qu'**il comprend une couche diélectrique (6) réalisée en un matériau diélectrique déposé sur la couche semi-conductrice (5), une électrode de grille (7) déposée sur la face supérieure de la couche diélectrique (6), une couche isolante (8) déposée sur la couche supérieure de la couche diélectrique (6) et l'électrode de grille (7), la couche piézoélectrique (9) étant déposée sur l'ensemble couche semi-conductrice (5) / couche diélectrique (6) / électrode de grille (7) / couche isolante (8) de telle manière que le matériau piézoélectrique soit en contact avec le matériau semi-conducteur et les deux électrodes (3, 4).

4. Capteur de pression selon l'une des revendications 1 à 3, ***caractérisé* en ce que** la couche piézoélectrique (9) comporte des dipôles alignés selon la direction de la pression exercée.

5. Capteur de pression selon la revendication 4, ***caractérisé* en ce que** les dipôles de la couche piézoélectrique (9) sont alignés en appliquant un champ électrique E entre les électrodes (3, 4).

6. Capteur de pression selon la revendication 4, ***caractérisé* en ce que** la couche piézoélectrique (9) reçoit une autre électrode (12), et **en ce que** un champ électrique E est appliqué entre l'électrode (12) et l'une, l'autre ou les deux électrodes (3, 4) déposées sur le substrat.

7. Capteur de pression selon l'une des revendications 5 et 6, ***caractérisé* en ce que** le champ électrique E appliqué entre les électrodes (3, 4), ou entre l'électrode (12) et l'une, l'autre ou les deux électrodes (3, 4) est compris entre 0,3 et 0,7 volt par micromètre à une température comprise entre 40 et 60 °C pendant une durée comprise entre 20 minutes et 8 heures.

8. Capteur de pression selon l'une quelconque des revendications 1 à 7, ***caractérisé* en ce que** le substrat inférieur (2) est réalisé en un matériau choisi dans le groupe comprenant le verre, le polycarbonate, le silicium dopé ou non, les polymères tels que le polyéthylène téréphtalate (PET), le polyéthylène naphthalate (PEN), le polyimide (PI) et les acrylates.

9. Capteur de pression selon l'une quelconque des revendications 1 à 8, ***caractérisé* en ce que** la couche semi-conductrice (5) est réalisée en un matériau choisi dans le groupe comprenant les molécules organiques semi-conductrices telles que tetracene, pentancene, phtalocyanine, les polymères semi-conducteurs tels que polythiophène, polyfluorène, polyphenylene vinylene ou leurs dérivés tels que poly (3-octyl), thiophene, poly [2-methoxy-5-(2'-ethyl-hexyloxy)-1,4-], phenylene, vinyilene ou oligomère tel que α-sexithiophènes..

10. Capteur de pression selon l'une quelconque des revendications 1 à 9, ***caractérisé* en ce que** la couche piézoélectrique (9) est réalisée en un matériau choisi dans le groupe comprenant le polyvinylidène fluoride (PVDF), les copolymères de polyvinylidène fluoride tels que PVDF-TrFE ou PVDF-TFE, et le PZT (Plomb - Zinc - Oxyde de titane)..

11. Capteur de pression selon la revendication 2, ***caractérisé* en ce que** la couche diélectrique (6) est réalisée en un matériau choisi dans le groupe comprenant le dioxyde de silicium, le nitrate de silicium, le dioxyde de titane, l'oxyde d'aluminium, le dioxyde d'hafnium, les polyimides, le polyvinyle, le pyrrolidone, le polymethylmethacrylate, le polyamide, le parylène, le polystyrène et les fluoropolymères.

12. Capteur de pression selon la revendication 3, ***caractérisé* en ce que** la couche isolante (8) est réalisée en un matériau choisi dans le groupe comprenant le dioxyde de silicium, le nitrate de silicium, le dioxyde de titane, l'oxyde d'aluminium, le dioxyde d'hafnium, les polyimides, le polyvinyle, le pyrrolidone, le polymethylmethacrylate, le polyamide, le parylène, le polystyrène et les fluoropolymères.

13. Capteur de pression selon l'une quelconque des revendications 1 à 12, ***caractérisé* en ce que** les électrodes (3, 4, 7) sont réalisées en un matériau choisi dans le groupe comprenant les métaux, tels que l'aluminium, le titane, le nickel, l'or, le chrome, etc..., les particules métalliques, les oxydes métalliques tels que l'oxyde d'indium-étain, l'oxyde d'indium-zinc, etc..., les polymères conducteurs tels que 3, 4 - polyéthylène dioxythiophène-polystirène, sulfonate (PEDOT : PSS) ou polyaniline, etc..., ou les matériaux en silicium dopé.

## Patentansprüche

1. Drucksensor (1) mit einem piezoelektrischen Material, **dadurch gekennzeichnet, dass** er mindestens ein unteres Substrat (2) aufweist, auf dem zwei Elektroden (3, 4) angeordnet sind, auf welche eine halbleitende Schicht (5) aus einem halbleitenden Material teilweise aufgetragen ist, und eine piezoelektrische Schicht (9) aus einem piezoelektrischen Material, die so mit der halbleitenden Schicht (5) in Kontakt steht, dass das halbleitende Material mit dem piezoelektrischen Material und mit den zwei Elektroden (3, 4) in Kontakt steht, wobei die piezoelektrische Schicht systematisch mit den Elektroden in Kontakt steht, wobei die Elektroden (3, 4) geeignet sind, mit einer Spannungsquelle oder mit einer Vorrichtung zur Messung der Stärke eines Stroms verbunden zu werden, der durch die Verschiebung der elektrischen Ladungen (10) in der halbleitenden Schicht (5) zwischen den Elektroden (3, 4) erzeugt wird, wobei die elektrischen Ladungen (10) erzeugt werden, wenn ein Druck auf die piezoelektrische Schicht (9) ausgeübt wird.

2. Drucksensor (1) nach Anspruch 1, **dadurch gekennzeichnet, dass** er ferner eine dielektrische Schicht (6) aus einem dielektrischen Material aufweist, die lokal zwischen die piezoelektrische Schicht (9) und die halbleitende Schicht (5) eingefügt ist.

3. Drucksensor (1) nach Anspruch 1, **dadurch gekennzeichnet, dass** er eine dielektrische Schicht (6) aus einem dielektrischen Material aufweist, das auf die halbleitende Schicht (5) aufgetragen ist, eine Gate-Elektrode (7), die auf der Oberseite der dielektrischen Schicht (6) angeordnet ist, eine Isolierschicht (8), die auf die obere Schicht der dielektrischen Schicht (6) und die Gate-Elektrode (7) aufgetragen ist, wobei die piezoelektrische Schicht (9) auf die Anordnung aus halbleitender Schicht (5) / dielektrischer Schicht (6) / Gate-Elektrode (7) / Isolierschicht (8) so angeordnet ist, dass das piezoelektrische Material mit dem halbleitenden Material und den zwei Elektroden (3, 4) in Kontakt steht.

4. Drucksensor (1) nach einem der Ansprüche 1 bis 3, **dadurch gekennzeichnet, dass** die piezoelektrische Schicht (9) Dipole aufweist, die in der Richtung des ausgeübten Drucks ausgerichtet sind.

5. Drucksensor nach Anspruch 4, **dadurch gekennzeichnet, dass** die Dipole der piezoelektrischen Schicht (9) durch Anlegen eines elektrischen Feldes E zwischen den Elektroden (3, 4) ausgerichtet werden.

6. Drucksensor nach Anspruch 4, **dadurch gekennzeichnet, dass** die piezoelektrische Schicht (9) eine weitere Elektrode (12) aufnimmt und dass ein elektrisches Feld E zwischen der Elektrode (12) und der einen, der anderen oder beiden Elektroden (3, 4), die auf dem Substrat angeordnet sind, angelegt wird.

7. Drucksensor (1) nach einem der Ansprüche 5 und 6, **dadurch gekennzeichnet, dass** das elektrische Feld E, das zwischen den Elektroden (3, 4) oder zwischen der Elektrode (12) und der einen, der anderen oder beiden Elektroden (3, 4) angelegt wird, zwischen 0,3 und 0,7 Volt pro Mikrometer bei einer Temperatur zwischen 40 und 60 °C für eine Dauer zwischen 20 Minuten und 8 Stunden liegt.

8. Drucksensor nach einem beliebigen der Ansprüche 1 bis 7, **dadurch gekennzeichnet, dass** das untere Substrat (2) aus einem Material hergestellt ist, das aus der Gruppe gewählt ist, die Glas, Polycarbonat, dotiertes oder nicht dotiertes Silizium, Polymere wie Polyethylenterephthalat (PET), Polyethylennaphtalat (PEN), Polyimid (PI) und Acrylate umfasst.

9. Drucksensor nach einem beliebigen der Ansprüche 1 bis 8, **dadurch gekennzeichnet, dass** die halbleitende Schicht (5) aus einem Material hergestellt ist, das aus der Gruppe gewählt ist, die die halbleitenden organischen Moleküle wie Tetracen, Pentacen, Phthalocyanin, halbleitende Polymere wie Polythiophen, Polyfluoren, Polyphenylenvinylen bzw. deren Derivate wie Poly(3-octyl), Thiophen, Poly[2-methoxy-5-(2'-ethylhexyloxy)-1,4-], Phenylen, Vinylen oder Oligomere wie α-Sexithiophene umfasst.

10. Drucksensor nach einem beliebigen der Ansprüche 1 bis 9, **dadurch gekennzeichnet, dass** die piezoelektrische Schicht (9) aus einem Material hergestellt ist, das aus der Gruppe gewählt ist, die Polyvinylidenfluorid (PVDF), Polyvinylidenfluorid-Copolymere wie PVDF-TrFE oder PVDF-TFE und PZT (Blei - Zink - Titanoxid) umfasst.

11. Drucksensor nach Anspruch 2, **dadurch gekennzeichnet, dass** die dielektrische Schicht (6) aus einem Material hergestellt ist, das aus der Gruppe gewählt ist, die Siliciumdioxid, Siliciumnitrat, Titandioxid, Aluminiumoxid, Hafniumdioxid, Polyimide, Polyvinyl, Pyrrolidon, Polymethylmethacrylat, Polyamid, Parylen, Polystyrol und Fluorpolymere umfasst.

12. Drucksensor nach Anspruch 3, **dadurch gekennzeichnet, dass** die Isolierschicht (8) aus einem Material hergestellt ist, das aus der Gruppe gewählt ist, die Siliciumdioxid, Siliciumnitrat, Titandioxid, Aluminiumoxid, Hafniumdioxid, Polyimide, Polyvinyl, Pyrrolidon, Polymethylmethacrylat, Polyamid, Parylen, Polystyrol und Fluorpolymere umfasst.

13. Drucksensor nach einem beliebigen der Ansprüche 1 bis 12, **dadurch gekennzeichnet, dass** die Elektroden (3, 4, 7) aus einem Material hergestellt sind, das aus der Gruppe gewählt ist, die Metalle wie Aluminium, Titan, Nickel, Gold, Chrom, usw., metallische Partikel, metallische Oxide wie Indiumzinnoxid, Indiumzinkoxid, usw., leitende Polymere wie 3,4-Polyethylendioxythiophen-Polystyrol, Sulfonat (PEDOT:PSS) oder Polyanilin, usw. oder Materialien aus dotiertem Silizium umfasst.

## Claims

1. A pressure sensor (1) comprising a piezoelectric material, wherein it comprises at least one lower substrate (2) having two electrodes (3, 4), partially covered with a semiconductor layer (5) made of a semiconductor material, deposited thereon, and a piezoelectric layer (9) made of a piezoelectric material, and in contact with the semiconductor layer (5) in such a way that semiconductor material is in contact with the piezoelectric material and with the two electrodes (3, 4), the piezoelectric layer being systematically in contact with the electrodes, said electrodes (3, 4) being capable of being connected to a voltage source or to a device for measuring the intensity of a current generated by the displacement of electric charges (10) in the semiconductor layer (5) between the electrodes (3, 4), said electric charges (10) being created when a pressure is exerted on the piezoelectric layer (9).

2. The pressure sensor (1) of claim 1, wherein it further comprises a dielectric layer (6) made of a dielectric material, locally inserted between the piezoelectric layer (9) and the semiconductor layer (5).

3. The pressure sensor (1) of claim 1, wherein it comprises a dielectric layer (6) made of a dielectric material deposited on the semiconductor layer (5), a gate electrode (7) deposited on the upper surface of the dielectric layer (6), an insulating layer (8) deposited on the upper surface of the dielectric layer (6) and the gate electrode (7), the piezoelectric layer (9) being deposited on the semiconductor layer (5) / dielectric layer (6) / gate electrode (7) / insulating layer (8) assembly in such a way that piezoelectric material is in contact with the semiconductor material and the two electrodes (3, 4).

4. The pressure sensor of any of claims 1 to 3, wherein the piezoelectric layer (9) comprises dipoles aligned along the direction of the exerted pressure.

5. The pressure sensor of claim 4, wherein the dipoles of the piezoelectric layer (9) are aligned by application of an electric field E between the electrodes (3, 4).

6. The pressure sensor of claim 4, wherein the piezoelectric layer (9) receives another electrode (12), an wherein an electric field E is applied between electrode (12) and one or the other of or the two electrodes (3, 4) deposited on the substrate.

7. The pressure sensor of any of claims 5 and 6, wherein the electric field E applied between the electrodes (3, 4), or between electrode (12) and one or the other of or the two electrodes (3, 4) is in the range from 0.3 and 0.7 volt per micrometer at a temperature in the range from 40 to 60°C for a time period between 20 minutes and 8 hours.

8. The pressure sensor of any of claims 1 to 7, wherein the lower substrate (2) is made of a material selected from the group comprising glass, polycarbonate, doped or undoped silicon, polymers such as polyethylene terephthalate (PET), polyethylene naphthalate (PEN), polyimide (PI), and acrylates.

9. The pressure sensor of any of claims 1 to 8, wherein the semiconductor layer (5) is made of a material selected from the group comprising semiconductor organic molecules such as tetracene, pentacene, phthalocyanine, semiconductor polymers such as polythiophene, polyfluorene, polyphenylene vinylene or derivatives thereof such as poly (3-octyl), thiophene, poly [2-methoxy-5-(2'-ethyl-hexyloxy)-1,4-], phenylene, vinylene or oligomer such as α-sexithiophenes.

10. The pressure sensor of any of claims 1 to 9, wherein the piezoelectric layer (9) is made of a material selected from the group comprising polyvinylidene fluoride (PVDF), polyvinylidene fluoride copolymers such as PVDF-TrFE or PVDF-TFE, and LZT (Lead - Zinc - Titanium oxide).

11. The pressure sensor of claim 2, wherein the dielectric layer (6) is made of a material selected from the group comprising silicon dioxide, silicon nitrate, titanium dioxide, aluminum oxide, hafnium dioxide, polyimides, polyvinyl, pyrrolidone, polymethylmethacrylate, polyamide, parylene, polystyrene, and fluoro-polymers.

12. The pressure sensor of claim 3, wherein the insulating layer (8) is made of a material selected from the group comprising silicon dioxide, silicon nitrate, titanium dioxide, aluminum oxide, hafnium dioxide, polyimides, polyvinyl, pyrrolidone, polymethylmethacrylate, polyamide, parylene, polystyrene, and fluoropolymers.

13. The pressure sensor of any of claims 1 to 12, wherein the electrodes (3, 4, 7) are made of a material selected from the group comprising metals such as aluminum, titanium, nickel, gold, chromium, etc..., metal particles, metal oxides such as indium-tin oxide, indium-zinc oxide, etc..., conductive polymers such as 3, 4 - polyethylene dioxythiophene-polystyrene, sulfonate (PEDOT:PSS) or polyaniline, etc..., or doped silicon materials.
